Europäisches Patentamt

European Patent Office

Office européen des brevets

(19)

(11) Publication number: **0 198 346**

**A2**

# EUROPEAN PATENT APPLICATION

(12)

(21) Application number: 86104580.5

(22) Date of filing: 04.04.86

(51) Int. Cl.4: **H01L 29/86** , H01L 27/14

(30) Priority: 08.04.85 US 720767

(43) Date of publication of application:
**22.10.86 Bulletin 86/43**

(84) Designated Contracting States:
**AT BE CH DE FR GB IT LI LU NL SE**

(71) Applicant: ENERGY CONVERSION DEVICES, INC.
**1675 West Maple Road**
**Troy Michigan 48084(US)**

(72) Inventor: **Guha, Subhendu**
**5366 Clearview**
**Troy Michigan 48098(US)**

(74) Representative: **Müller, Hans-Jürgen, Dipl.-Ing. et al**
**Müller, Schupfner & Gauger**
**Lucile-Grahn-Strasse 38 Postfach 80 13 69**
**D-8000 München 80(DE)**

(54) **Solid-state threshold devices using punch-through.**

(57) A threshold device (10,54,82) is provided which passes very little current when the voltage applied across it is below its threshold voltage and which can pass a large amount of current when the voltage applied across it exceeds that threshold. The threshold device comprises a common body (12,62) of deposited amorphous semiconductor material and two separate electrical contacts (18,19), each having a junction forming portion (20,21; 60,64; 52,65) in contact with the common body. The junction forming portions each form a junction (22,24) having a depletion region (26,28) in the semiconductor material of the common body. As a result, when a voltage is applied between the two contacts, one of the junction is forward biased and the other is reverse biased. Both the spacing between the junctions and the electrical properties of the common body and the junctions are such that when the threshold voltage is applied between the contacts, the depletion region of the reverse biased junction extends all the way to the depletion region of the forward biased junction, greatly increasing the conductivity between said two contacts. The threshold voltage at which such a punch-through of the depletion regions occurs is less than the voltage required to cause avalanche breakdown across the reverse biased junction. Among other things, such threshold devices are used as isolation devices (54,82,92,94,102,104) for the individual pixels (42) of a light influencing display (40).

FIG. IA

FIG. IB

FIG. IC

FIG. ID

## SOLID-STATE THRESHOLD DEVICES USING PUNCH-THROUGH

### FIELD OF THE INVENTION

The present invention relates to solid-state threshold devices of the type which have a very high resistance and which pass very little current when the voltage applied across them is below their threshold voltage, and which have a much lower resistance and which pass a much greater current when the voltage applied across them is above their threshold. The present invention also relates to light influencing displays which use such threshold devices as isolation devices for their individual pixels.

### BACKGROUND OF THE INVENTION

Many very important electronic functions are performed by circuit elements which have a non-linear relationship between the voltage applied across them and the current which flows through them. An important type of non-linear circuit element is· the threshold device which provides a high resistance to current flow when the voltage across it is below a threshold voltage and a low resistance to current flow when the voltage across it is above that threshold. Such threshold devices can be considered single threshold devices because the threshold at which their current turns on is substantially the same as the threshold at which their current turns off. They are distinguished from two threshold devices, such as the Ovonic Threshold Switch, described as a "mechanism device" in U.S. Patent No. 3,271,591 for "Solid State Current Controlling Device" issued to Stanford R. Ovshinsky on September 6, 1966, which was assigned to the assignee of the present invention. In the Ovonic Threshold Switch, current turns on at a first threshold voltage, and turns off at a second, substantially lower, threshold voltage. In the remainder of this specification and in the claims that follow, the term "threshold·device" or "threshold switch" refers to a single threshold device of the type described above.

Threshold devices have many uses. They are used as clamps to limit the voltage difference between two conductors. To clamp the voltage between two conductors, a threshold device is connected between them. Whenever the voltage difference between the conductors exceeds the threshold voltage of the device, the device turns on, allowing current to flow between the conductors. This current flow reduces the voltage difference between the conductors until that difference drops to the threshold voltage, at which point the threshold device turns off, preventing a further drop in the voltage difference. Threshold devices can also be thought of as current controlling devices, since they prevent the flow of current along a circuit path which is in series with such a threshold device unless the voltage applied across that path is sufficient to turn the threshold device on.

One important use for threshold switches is as isolation devices for the individual pixels of light influencing displays, such as liquid crystal displays. In such displays, each pixel, or picture element, is formed of two electrodes separated by a light influencing material which changes its optical property when a voltage is applied across it. Such displays commonly use x-y addressing schemes, in which the pixels are divided into rows and columns, with a separate x-line connected to all the pixels in each row and a separate y-line connected to all the pixels in each column. As a result, each pixel has one of its electrodes connected to an x-line and one to a y-line. This scheme has the advantage of allowing a large number of pixels to be addressed with a minimum number of lines. But since it causes pixels to share address lines, it makes it impossible to address all the pixels at once. Thus the pixels are usually addressed repeatedly in a sequential manner, one row at a time. Unfortunately, however, as the number of rows increases, the percentage of time which a signal voltage can be applied across the pixels of a given row decreases. In displays in which the pixels are connected directly to both their address lines, this causes the RMS voltage across each pixel to decrease, diminishing the visible contrast between pixels that are on and those that are off.

In order to solve this problem, the prior art has placed isolation devices between .pixels and their associated address lines. Such devices electrically isolate each pixel during the period when it is not addressed, so that a signal voltage placed across a pixel when it is addressed tends to be held by the pixel's capacitance until the pixel is addressed again. This greatly increases the RMS valve of the voltage applied across the pixel, and thus greatly improves the display's contrast.

Threshold switches function as such isolation devices when placed in series between each pixel and at least one of its address lines. When the pixel is addressed, the voltage applied across the pixel and its threshold switch is selected to be sufficient to turn the threshold switch on, enabling charge to be added or removed from the pixel. However, when the pixel is not addressed, the voltage across it and its associated threshold switch is selected to be sufficiently low that it turns the switch off, preventing charge from flowing off the pixel.

The prior art has provided a plurality of solid-state threshold devices. Perhaps most common among them is the diode. An ideal diode acts as a threshold device because it conducts very little current unless the voltage applied across it exceeds the threshold voltage required to forward bias it. Such diodes are often used to control the flow of current in logic circuits and to provide voltage clamps. Unfortunately, the threshold voltage associated with diodes is determined by the semiconductor materials used, and normally is limited to less than one volt. Also diodes are not symmetrical devices. Their current/voltage curve in a direction that forward biases them is very different than in the opposite direction. This is a disadvantage for some circuit applications, such as those involving liquid crystal displays, as is described below.

One important use of diodes is as the isolation devices in light influencing displays. An example of diodes used as such threshold switches is shown in U.S. patent application Serial No. 573,004 for "Liquid Crystal Displays Operated By Amorphous Silicon Alloy Diodes" filed by Yaniv, et al on January 24, 1984, which is assigned to the assignee of the present application, and which is incorporated herein by reference (see corresponding European patent application Serial No. 85100192.5 filed January 10, 1985). Although diodes function well as such isolation devices, it would be desirable to have a bidirectional threshold device which had a higher threshold voltage than can be achieved with normal diodes.

As was stated above, diodes are unidirectional threshold devices. This is a disadvantage in liquid crystal displays, since it is necessary to periodically reverse the voltage across each pixel to prevent the pixel from being damaged by electrolysis. Thus in prior art displays in which diodes are used as isolation elements, two diodes are usually required for each pixel, one to provide a threshold voltage for each direction of current flow. It is possible to connect the two oppositely directed diodes in parallel between a pixel electrode and its associated address line. Two such diodes in parallel create a bidirectional device called a ring-diode, with one diode providing a threshold in a forward direction and one diode providing a threshold in the opposite direction. Unfortunately, however, the low threshold voltages provided by diodes causes the difference between the forward and reverse thresholds of the ring diode to be too small for many display applications. This problem can be overcome by placing a series of like-directed diodes in each of the two parallel branches of the ring diode, but this increases the complexity of circuitry associated with each pixel.

It is also possible to have each of the two diodes connected to a given pixel electrode connected to a separate address line. This is shown in U.S. patent application, Serial No. 573,004 referred to above (see corresponding European patent application, Serial No. 85100192.5 filed January 10, 1985). Although such an arrangement functions well, it has the disadvantage of requiring two address lines per row of pixels, instead of the one which would be required if bidirectional threshold devices were used.

One type of bidirectional threshold switch is discussed in considerable detail in U.S. Patent Application Serial No. 603,852, entitled "Programmable Semiconductor Switch For A Display Matrix Or The Like And Method For Making Same", filed on April 25, 1984, by W. den Boer et al, which is assigned to the assignee of the present application. In a preferred embodiment, this threshold device is an N-I-N switch, fabricated of a layer of I type amorphous semiconductor material surrounded by two layers of N type amorphous semiconductor material. This switch is designed to have both a positive and a negative threshold voltage at which it becomes conducting and below which it is non-conducting. Since it is made of amorphous materials, it is suitable for use in liquid crystal displays fabricated on glass substrates, and it can be programmed by light to increase the value of its threshold.

The N-I-N device described in the above mentioned U.S. patent application Serial No. 603,852 exhibits variable resistance as a function of the percent of the traps in the energy gap between the valence and conduction band of its middle intrinsic layer which are full. At low applied voltages a low percent of the traps are filled, and thus these traps tend to block current flow. But once the applied voltage is high enough that a high percent of the traps are filled, the effective mobility of the intrinsic layer greatly increase, turning the device on.

Prior art threshold devices also include breakdown diodes. As is well known in the art, when the reverse bias across most diodes reaches a certain voltage, avalanche breakdown occurs, causing the diodes to switch over a relatively narrow voltage range from a highly non-conductive, reverse biased state to a highly conductive, reverse breakdown state. A bidirectional threshold device can be made by placing two oppositely facing breakdown diodes in series. At voltages below its threshold such a device tends to prevent current flow in either direction, because one of the diodes will be reverse biased by any applied voltage. However, if the applied voltage exceeds the device's threshold voltage, the diode which is reverse biased undergoes avalanche breakdown, causing that diode and the bidirectional device of which it is part to conduct. For example, such a bidirectional threshold device can be made by placing a semiconductor material between two metal conductors which form Schottky barriers with the semiconductor. Thus the device forms two series connected back-to-back diodes. As described above, the device tends to prevent current flow in either direction until the voltage applied across it is sufficient to cause avalanche breakdown in its reverse biased diode. Once such avalanche occurs, the device's conductivity increases rapidly.

Other breakdown devices have been made which do not include diodes, and which rely on the relatively low conductivity of their semiconductor material to provide a high resistance during their off state. For example, the MSM breakdown device has a semiconductor material placed between two metal conductors. The metal conductors do not need to form Schottky barriers with the semiconductor material. When the voltage across the device in either direction exceeds the breakdown voltage of the semiconductor, the device turns on.

Breakdown devices have certain disadvantages, particularly breakdown devices constructed of amorphous semiconductor materials suitable for fabrication on glass substrates of light influencing displays. Such devices sometimes have hot spots and instabilities which tend to make their performance less than totally predictable, and which, in some cases, lead to degradation of their performance.

Another type of well known threshold device is the Zener tunnel diode. Such diodes exhibit the Zener effect, in which, above a certain threshold voltage, tunnelling occurs across a reverse biased diode junction, causing the diode to change from a highly non-conductive state to a highly conductive state over a narrow voltage range. Zener tunnel diodes, however, require very narrow semiconductor junctions to function properly, and the range of threshold voltages which a tunnel diode can have is somewhat limited. In addition, it has proven difficult to make Zener tunnel diodes with sharply defined threshold voltages using amorphous semiconductor materials.

Another type of tunnelling device is the metal-insulator-metal, or MIM, tunnel diode. In an MIM device a very thin layer of insulating material, usually less than several hundred angstroms thick, is placed between two conducting metal layers. Such a device is bidirectional, having a threshold in both directions across the insulator. At low voltages the insulating layer substantially prevents current flow, but as the voltage across the device is increased charge carriers tunnel across the insulator, causing the device to conduct. However, the very small spacing between the conductive layers of such MIM devices causes them to have a high capacitance which slows down their operation.

One prior art threshold device which has a sharply defined threshold voltage is the BARITT diode. A BARITT diode normally consists of two back-to-back semiconductor junctions which share a common central crystalline semiconductor region. Some BARITT diodes are formed by placing a thin layer of lightly doped crystalline semiconductor material between two layers of metal which form Schottky barriers with it. Other BARITT diodes contain a lightly doped crystalline semiconductor material placed between two layers of heavily doped crystalline semiconductor material of the opposite conductivity type.

When a voltage is applied across the two semiconductor junctions of the BARITT diode, one of them is forward biased and one is reverse biased, and the reverse biased junction substantially prevents current from flowing across the BARITT diode at low voltages. However, as the voltage across the BARITT diode increases, the depletion region formed in the central semiconductor by the reverse biased junction increases in depth. When the voltage is increased to the point that this depletion region extends all the way across the central semiconductor material and touches the small depletion region associated with the forward biased junction, an effect known as punch-through occurs. In punch-through the entire length of the central semiconductor between the forward and reverse biased junctions is depleted, and thus a relatively strong field extends across that whole region. Because of that strong field, any carriers injected across the forward biased junction are swept by the relatively high field in the depleted central semiconductor all the way to the other junction. As a result, the current flow in a BARITT diode increases sharply as soon as the voltage placed across it is sufficient to achieve punch-through. The BARITT diodes constructed in the prior art have transitions betwen their on and off states which are as sharp, or sharper than, those associated with conventional Zener or breakdown diodes.

Another benefit of the BARITT diode is the symmetry of its current/voltage curve. If its back-to-back semiconductor junctions are symmetrical with each other, the BARITT diode's threshold voltage in both its forward and reverse directions are substantially identical. This symmetry is very desirable for certain bi-directional voltage driving schemes, such as those used in many liquid crystal displays.

Unfortunately BARITT diodes have been fabricated using crystalline semiconductor materials only. Fabricating such diodes out of crystalline materials limits their use for many applications. As is well known, crystalline materials cannot be deposited on most substrates. Instead they must either be crystallized at high temperatures or be grown epitaxially upon a crystalline substrate. As a result, for example, it is not possible to fabricate a crystalline device upon a glass substrate, such as might be desired for use in low cost liquid crystal displays. In addition, crystalline integrated circuit cannot be made any larger than a single crystalline wafer, and presently it is difficult to fabricate crystalline wafers much larger than 6 inches in diameter. This is a real hindrance to the use of BARITT diodes in association with the individual pixels of large area liquid crystal displays, such as ones the size of most television screens.

SUMMARY OF THE INVENTION

The present invention relates to a threshold device formed of deposited semiconductor material which operates by punch-through, as is described below. The threshold device comprises a common body of deposited amorphous semiconductor material and two separate electrical contacts, each having a junction forming portion touching the common body. The junction forming portions of each of the electrical contacts form a junction with the semiconductor material of the common body which has a depletion region in that semiconductor material. As a result, when a voltage is applied in one direction between the two contacts, one of the junctions is forward biased and the other reverse biased. The electrical properties of the semiconductor material and the junction, as well as the spacing between the junctions, are chosen such that when a pre-selected, or threshold, voltage is applied between the contacts, the depletion region formed in the reverse biased junction extends all the way to the depletion region of the forward biased junction, greatly increasing the conductivity between the two contacts. In order for the present invention to work, punch-through, that is the extension of the depletion region from the reverse biased junction all the way to the depletion region of the forward biased junction, must occur at a pre-selected voltage less than the voltage at which avalanche breakdown occurs across the reverse biased junction.

In a preferred embodiment of the invention, the semiconductor material of the common body has a first conductivity type, either p type or n type. This can be achieved by using substantially intrinsic amorphous silicon alloys for the material of the common body, since such intrinsic amorphous silicon alloys have a slight n-type conductivity. The conductivity type of the common body can also be achieved by means of doping. In certain preferred embodiments of the invention, the junction forming portions are made of a semiconductor material having the opposite conductivity type from the semiconductor material of the common body. Preferably such junction forming portions are more heavily doped than the semiconductor material of the common body. The semiconductor material used in the junction forming portion of such embodiments can be a deposited amorphous semiconductor material, such as an amorphous alloy of silicon, including hydrogen or fluorine, or both, as a density of states reducing element. Preferably the deposited amorphous semiconductor material of the junction forming portions is a microcrystalline material. In an alternative embodiment of the invention, the junction forming portion of the non-linear device is made of a metal which forms a Schottky barrier junction in contact with the semiconductor material of the common body.

Preferably, the spacing between the junctions of the non-linear device through its common body is between 2,000 and 5,000 angstroms and the semiconductor material of the common body is an amorphous alloy of silicon including hydrogen or fluorine, or both, as a density of states reducing element.

According to one embodiment of the present invention, an electrical device is provided which comprises two electrical conductors and two threshold devices of the type described above. The two threshold devices are electrically connected between the two conductors so that the application of a voltage between the two conductors causes a voltage to be applied between the two electrical contacts of each of the two threshold devices. The two threshold devices can be connected either in series or in parallel between the two conductors. In many preferred embodiments the threshold devices are formed on a substrate, with the common body of each of the two threshold devices being deposited on top of a first, lower one of the threshold device's junction forming portions. The second, upper, junction forming portion of each threshold device is formed of a material deposited on top of the threshold device's common body. The two threshold devices are electrically connected between the two conductors so that when a voltage is applied between the two conductors, the field between the upper and lower junction forming portions of one of the two threshold devices is opposite in direction to the field between the upper and lower junction forming portions of the other of the two threshold devices. This tends to cause any asymmetries in the current/voltage characteristics of the two threshold devices to cancel out, so that the combination of the two threshold devices has a substantially symmetrical current/voltage characteristic with regard to the polarity of applied voltage.

According to one embodiment of the present invention a light influencing display is provided which includes a plurality of pixels, each including two opposing electrode surfaces with light influencing material in between and a plurality of address lines enabling each of the pixels to be selectively addressed. According to this embodiment of the invention, a threshold device of the type described above is placed in electrical series between an electrode surface of at least one of the pixels and at least one of the address lines used to address that pixel. Preferably, each pixel has one or more such threshold devices to function as an isolation device between it and one or more of its associated address lines. In a preferred embodiment the light influencing display includes substrate formed of a material such as glass. In such an embodiment at least one of the electrode surfaces of each pixel, at least one address line used to address each pixel, and at least one threshold device associated with each pixel are formed of deposited materials upon the substrate. Preferably, the two junction forming portions and the common body of each threshold device are each formed of a layer of deposited material supported by the substrate, with the layer of the common body located between the layers of the two junction forming portions.

In one preferred embodiment, two threshold devices of the type described above are electrically connected between the electrode surface of at least one pixel and at least one address line, so that the application of a voltage between the electrode surface and the address line causes a voltage to be applied between the two electrical contacts of each of the two threshold devices. These two threshold devices can be connected either in parallel or in series between the electrode surface and the address line. In many preferred embodiments, the two threshold devices are formed on a substrate with a common body of each of the two threshold devices being formed of a semiconductor material deposited on top of a first, lower one of the two threshold devices' junction forming portions. The second, upper, junction forming portion of each of the two threshold devices is formed of material deposited on top of the threshold device's common body. The two threshold devices are electrically connected between the electrode surface and the address line, so that when a voltage is applied between the electrode surface and the address line, the field between the upper and lower junction forming portion of one of the threshold devices is opposite in direction to the field between the upper and lower junction forming portions of the other of the two threshold devices.

The present invention also provides a subassembly for use in a light influencing display of the type described above. Such a subassembly includes a substrate, a plurality of pixel electrodes formed on the substrate, a plurality of address lines formed on the substrate, and a plurality of threshold devices of the type provided by the present invention formed on the substrate. As is described above with regard to the light influencing display, two such threhold devices can be connected between a given pixel electrode and its associated address line, either in series or in parallel.

The present invention also provides a method of forming a threshold device of the type described above. This method includes depositing a common layer of amorphous semiconductor material on a substrate having a first junction forming portion on its surface, and then depositing a second junction forming portion on top of the common layer. As described above, the junction forming portions form junctions having depletion regions in the semiconductor material of the common layer. As a result, when a voltage is appleid in one direction between the two junction forming portions, one of the junctions is forward biased and the other is reverse biased. The spacing between the junctions and the electrical properties of both the semiconductor material and the junctions are selected such that when a pre-selected voltage is applied between the junction forming portions, the depletion region formed in the reverse biased junction extends all the way to the depletion region of the forward biased junction, greatly increasing the conductivity between the two contacts. This device is made so that this preselected voltage is less than the voltage at which avalanche breakdown occurs across the reverse biased junction.

In a preferred embodiment, the method also includes depositing the first junction forming portion upon the substrate before the deposition of the common layer. In one embodiment, all three layers, the first and second junction forming layers and the common layer are each deposited as continuous layers over an extended region of the substrate and then all three layers are etched together in one

6

photolithographic etching process to form a plurality of non-linear devices. In other embodiments photolithography is done after one or two layers have been depositied.

Preferably, the amorphous semiconductor material of the common layers is deposited by glow discharge deposition upon the substrate and the susbtrate is kept at a temperature between 250° and 300° centigrade during deposition, which is cool enough to enable the substrate to be made of glass. In certain embodiments the substrate is kept away from air between the deposition of the first junction forming portion and the deposition of the second junction forming portion; to prevent the junctions between the junction forming portions and the common layer from being contaminated by gases that might undesirably alter the electrical characteristics of the threshold device.

These and other aspects and embodiments of the present invention are described in greater detail in the specification which follows.

## BRIEF DESCRIPTION OF THE DRAWINGS

In the drawings, which form an integral part of the specification of the present application and which are to be read in conjunction therewith, and in which like reference numerals are employed to designate similar components of various views:

Figures 1A and 1C are schematic diagrams of a threshold device according to the present invention, with Figure 1A representing the device when the voltage applied across it is below its threshold, and with Figure 1C representing it when the voltage applied across it exceeds its threshold,and Figures 1B and 1D show the electric fields along the length of the threshold device when it is biased as shown in Figures 1A and 1C respectively;

Figure 2 shows the current versus voltage curve of the device shown in Figures 1A and 1C;

Figure 3 is a schematic top-plan view of a liquid crystal display embodying the present invention;

Figure 4 is a partial cross-sectional side view of a liquid crystal display and a threshold device contained within it, both of which embody the present invention;

Figures 5A through 5F are a series of partial cross-sectional side views of a bottom substrate assembly used to form a liquid crystal display of the type shown in Figure 4, with successive steps used in the formation of that subassembly being shown in successive views;

Figure 6 is a partial cross-sectional side view of a bottom substrate assembly for use in a liquid crystal display which is similar to that shown in Figure 4, except that its threshold device is formed of a layer of semiconductor material placed between two layers of metal, which form Schottky barriers with the semiconductor material;

Figure 7 is a schematic representation of an embodiment of the invention in which two threshold devices are electrically connected in series;

Figure 8 is a schematic circuit representation of an embodiment of the invention in which two threshold devices are electrically connected in parallel;

Figure 9 is a schematic electrical representation of one pixel of a light influencing display with its associated x and y address lines and with one of the electrodes of the pixel being connected to its associated address line through two threshold devices connected in series;

Figure 10 is a partial cross sectional side view of a bottom substrate assembly for use in a liquid crystal display in which a pixel electrode is connected to its associated address line through two threshold devices connected in series;

Figure 11 is a schematic electrical circuit diagram showing a pixel electrode of a light influencing display with its associated x and y address line with one of the electrodes being connected to its associated address line through two threshold devices connected electrically in parallel;

Figure 12 is a partial top view of a bottom substrate assembly for use in a liquid crystal display in which a pixel electrode is connected to its associated address line through two threshold devices connected in parallel; and

Figure 13 is a partial cross sectional side view of the bottom substrate assembly shown in Figure 12 taken along the lines 13-13, 13'-13', and 13"-13" shown in Figure 12.

## DETAILED DESCRIPTION OF PREFERRED EMBODIMENTS

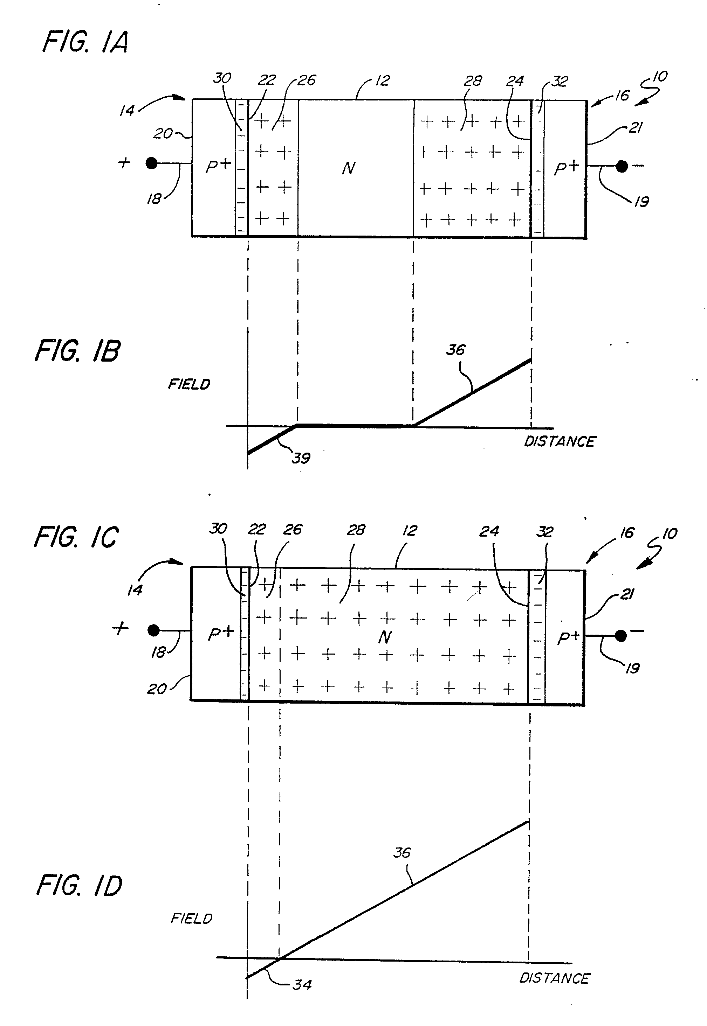

Referring now to Figure 1A, a schematic representation of a non-linear circuit device 10 embodying the present invention is shown. The circuit device 10 comprises a common body 12 of deposited amorphous semiconductor material. By the term "amorphous" is meant an alloy of material which has long range disorder, although it may have short or intermediate order, or even contain crystalline inclusions. The device 10 further includes two separate electrical contacts 14 and 16. Each of the electrical contacts 14 and 16 includes a conductive electrical terminal 18 or 19, respectively, and a junction forming portion 20 or 21, respectively. Each of the junction forming portions is made of a material which forms a semiconductor junction 22 or 24 having an associated depletion region 26 or 28, respectively, in the semiconductor material of the common body 12.

In the embodiment of the invention shown in Figure 1A, the two junction forming portions 20 and 21 are both formed of a deposited, heavily doped p+ amorphous semiconductor material. Because these junction forming portions are much more heavily doped than the lightly doped n-type semiconductor material of the common body, the depletions regions 30 and 32 formed in the junction forming portions are extremely thin when compared to the depletion regions formed in the central body. The relative thickness of the depletion regions 30 and 32 has been exaggerated in Figures 1A and 1C for purpose od illustration.

The common or central body 12 of amorphous semiconductor material is made of an intrinsic or lightly doped amorphous semiconductor material. This is because it is difficult to make good rectifying junctions between two heavily doped amorphous semiconductors or a metal and a heavily doped amorphous semiconductor, due to tunnelling across the junction caused by the large number of defect states which exist in heavily doped amorphous semiconductors.

It can be seen from Figure 1A that the polarity of the junctions 22 and 24 are opposite relative to each other. Thus when a voltage is applied between the two terminals 18 and 19, as is indicated in Figure 1A, one of the junctions (22 in Figure 1A) is forward-biased, and the other (24 in figure 1A) is reverse-biased. Since the two depletions regions 26 and 28 are separated from each other when the voltage applied across the device 10 is low, the device acts substantially like two back-to-back diodes separated by a resistance, with the reverse-biased junction 24 preventing any substantial flow of current across the device.

Figure 1B is a diagram showing the field strength as a function of distance along the length between the two junctions 22 and 24. As can be seen from Figure 1B, the fields associated with each of the depletion regions 26 and 28 extend only as far as those depletion regions, and thus do not meet when the voltage applied across device 10 is too low to cause the depletion regions 28 and 26 to join.

As is well known, when the voltage across a reverse-biased semiconductor junction is increased, the widths of the depletion regions of that junction are correspondingly increased. On the other hand, when the voltage across a forward-biased junction is increased, the widths of its depletion regions are decreased. When the voltage applied between the terminals 18 and 19 of the device 10 is increased, the width of the depletion region 28 of the reverse-biased junction 24 increases, and the width of the depletion region 26 associated with the forward-biased junction 22 decreases. When the voltage between the junctions is increased to a preselected threshold voltage, the device reaches a state called punch-through, in which the reverse-biased depletion region 28 reaches all the way to the depletion region 26 of the forward-biased junction.

This state of punch-through is shown in figure 1C, in which the entire length of the common body 12 has been depleted. Figure 1D showns the corresponding field strength associated with the device 10 when such punch-through has been achieved. As is shown in Figure 1D, the field 36 associated with the depletion region of the reverse-biased junction 24 touches the opposing field 34 associated with the forward-biased junction 22. As a result, any of the majority carriers, or holes, in the p+ junction forming region 20 which diffuse over the barrier presented to them by the field 34 immediately enter the opposing field 36 associated with the reverse-biased junction 24. This field tends to rapidly pull such holes toward, and then across, the junction 24 into the opposite junction forming portion 21.

Thus, once punch-through is reached, the device 10 ceases acting as two separate back-to-back diodes connected by a resistor, and begins to act somewhat like a bipolar transistor with a forward-biased base-emitter junction. According to this analogy, the junction forming portion 20 which forms the forward-biased junction 22 acts like an emitter, the common body of n material 12 acts like a base, and the junction forming portion 21 which forms the reverse-biased junction 24 acts like the collector. A high percent of those majority carriers from the emitter-like junction forming portion 20 which manage to cross the relatively low barrier formed by the field 34 of the forward-biased junction are swept by the field 36 of the reverse-biased junction to the collector-like junction forming portion 21. As a result of these effects, the current across the device 10 increases very sharply when punch-through is achieved.

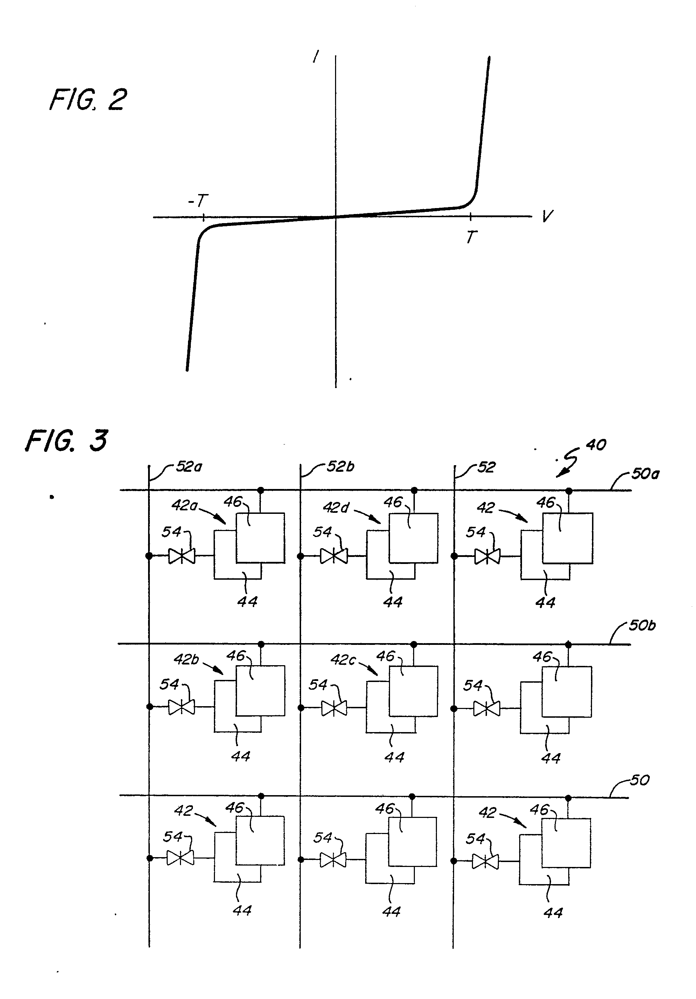

Figure 2 is a graph showing the current/voltage function of the device 10. As can be seen from Figure 2, this function is substantially symmetrical with regard to the voltage polarity. This is because the device shown in Figures 1A and 1C is itself symmetrical with regard to the direction between its two terminals. As can be seen from the Figure 2, there is very little current flow between terminals 18 and 19 until the voltage between them exceeds a threshold voltage (T) in either direction. When this threshold voltage is exceeded, the current increases very rapidly due to the punch-through effect described above. In fact, experiments have indicated that in certain regions above the threshold voltage, current increases in proportion to between the eighth and twelfth power of the increase in voltage. Tests have also confirmed that devices constructed according to the present invention provide bi-directional threshold devices which switch from a virtually non-conductive state to a highly conductive state at a very sharply defined threshold voltage.

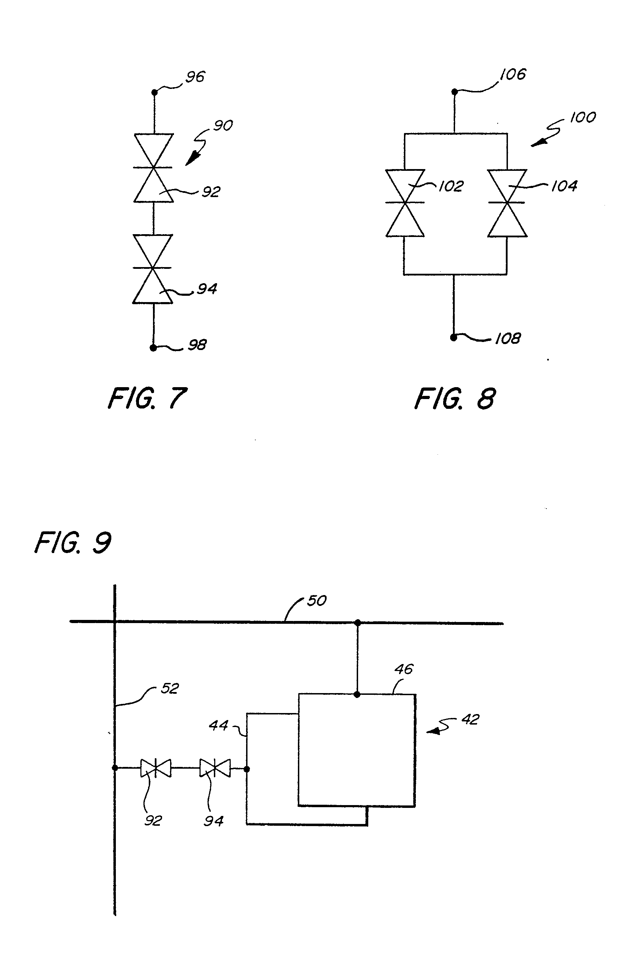

An almost exactly symmetrical current/voltage characteristic, of the type shown in Figure 2, is only obtained if the three layers formed by the junction forming portion 20, the common body 12, and the junction forming portion 21 are deposited consecutively without breaking vacuum between the deposition of such layers. If, for reasons of fabrication efficiency, the vacuum is broken between the deposition of layers, the resulting device may have an asymmetrical current/voltage characteristic due to the contamination of the surface of such layers by atoms from air. As is described below with regard to Figures 7-13, two such asymmetrical devices can be combined to form a circuit element in which their asymmetries cancel out, causing the combination to have a symmetrical current/voltage characteristic.

The threshold required to achieve punch-through in devices of the present invention can be tailored to have any desired value over a relatively broad range of voltages. The inventor's initial experiments have already produced devices with threshold voltages ranging from 4 to 6 volts, and a threshold voltage ranging from 3 to 8 volts should be achievable.

The threshold voltage of devices embodying the present invention can be increased by increasing the distance between the junctions 22 and 24, and can be decreased by decreasing that distance. Similarly the threshold voltage can be varied by altering the doping levels in the common body 12 and the junction forming portions 20 and 21. Increasing the doping concentration in the semiconductor material of the common body 12 tends to decrease the width of the depletion regions 26 and 28 formed within it. This increases the threshold voltage required to make the depletion regions 26 and 28 extend all the way between the junctions 22 and 24. On the other hand, increasing the concentration of the dopants used in the junction forming portions 20 and 21 tends to increase the width of the depletion regions 26 and 28, tending to decrease the threshold voltage associated with such devices.

The tailorability and relatively high level of the threshold voltages associated with the devices of the present invention make such devices suitable for a broad range of applications. For example, it makes them excellent for use as isolation devices in many light influencing displays.

Although the threshold voltages of devices made according to the present invention can be increased considerably by increasing the distance between their opposing junctions 22 and 24, there is a limit to how high such threshold voltages can be made. This limit arises because there is a limit to the strength of the field which the semiconductor material of the common body 12 can withstand before it undergoes avalanche breakdown. In general, amorphous semiconductor materials undergo such breakdown at lower voltages than do crystalline materials. This is because there is a relatively large number of defect states in the energy gap between the conduction and valence bands of such amorphous materials as compared to the number of such defect states in crystalline semiconductor materials. This relatively large number of defect states tends to increase the likelihood of avalanche breakdown. In fact, early amorphous semiconductor materials had so many defect states in their energy gap that the use of amorphous materials in punch-through devices was practically unthinkable. However, major advances have been made in the quality of amorphous semiconductor materials, both by the assignee of the present invention and others. The inventor of the present invention has realized that the quality of such materials now makes it possible to use them to construct a punch-through device.

Even though there is a limit on how high the threshold of the individual devices of the present invention can be made, such devices can be connected in series to form combination devices with thresholds equal to the sum of the threshold of its individual component devices. Such series connected combinations are discussed in greater detail below with regard to Figure 7.

Referring now to Figure 3, a liquid crystal display 40 is shown schematically. The display 40 is comprised of an array of pixels 42. For purposes of simplification, the display 40 is shown as having only a 3 x 3 array of pixels. It is to be understood, however, that in most actual embodiments of the invention, much larger arrays of pixels are used. Each of these pixels consist of a bottom pixel electrode 44 and a top pixel electrode 46. For purposes of simplification, the layer of liquid crystal material 48 placed between the two electrodes of each pixel is not shown in Figure 3. Each of the top electrodes 46 in a given row of pixels is connected to an x line 50. Correspondingly, each of the bottom electrodes 44 in a column of pixels is connected to a y line 52.

- Each bottom pixel 44 is connected to its associated y line 52 through a threshold device 54 made according to the present invention. These threshold devices 54 function as isolation devices, in a manner similar to that discussed above in the Background of the Invention. Thus, if an individual pixel such as the pixel 42a in the upper left hand corner of the array of pixels shown in Figure 3 is to be addressed, the x line 50a connected to its upper electrode 46 and the y line 52a connected through the threshold switch 54 to its bottom electrode 44 have a signal voltage applied between them.

If the pixel 42a is to be turned on, the signal voltage applied between the lines 50a and 52a is equal to the sum of (a) the threshold voltage required to turn the device 54 on, and (b) the additional voltage required to turn the pixel 42a on. Assume, for example, that the threshold of the isolation devices 54 is 5 volts and the voltage required to turn the liquid crystal of the pixel 42a totally on is 2 volts. In this case the voltage applied between the lines 50a and 52a is approximately 7 volts.

On the other hand, if the pixel is to have the voltage across it set to zero volts, so as to turn it off, the signal applied between the address lines 50a and 52a is set approximately to the 5 volts threshold voltage of the isolation device 54. As is explained in greater detail below, the polarity of the voltage applied across each pixel is alternated every time the pixel is addressed. As a result, the polarity of any charge remaining on the pixel from its previous addressing adds to, rather than subtracts from, the voltage across the pixel's isolation device when the pixel is subsequently addressed. Thus, if the pixel has a retained charge of about 1.8 volts from its previous addressing and 5 volts is applied between the pixel's address lines, a total of 6.8 volts is applied across the pixel's isolation device. This turns that device on, causing charge to be removed from the capacitance of the pixel. Since the voltage applied between the x and y lines is selected to equal the threshold of the isolation device, the pixel continues to discharge until there is substantially no voltage across it. Of course, if the pixel has no charge to begin with, it will similarly be left without charge after the application of 5 volts between its address lines, since the 5 volt voltage drop across the threshold device 54 leaves substantially no voltage left to be applied across the pixel.

An advantage of the isolation device of the present invention is the fact that it is symmetrical with respect to voltage polarity, as is shown in Figure 2. This is important, since in liquid crystal displays it is necessary to alternate the polarity of the voltage applied across individual pixels to prevent deterioration of those pixels due to electrolysis. Thus it is preferred that the polarity of the voltage applied across the pixels of a liquid crystal display be reversed periodically. This is commonly done by sequentially readdressing all the pixels in a display once every video field period, with the polarity of the voltage applied across the pixels being alternated once every field period. Because the isolation device 54 is symmetrical with respect to voltage polarity, it works equally well with respect to voltages applied between the x and y lines in one direction as it does with regard to voltages applied between those lines in the opposite direction.

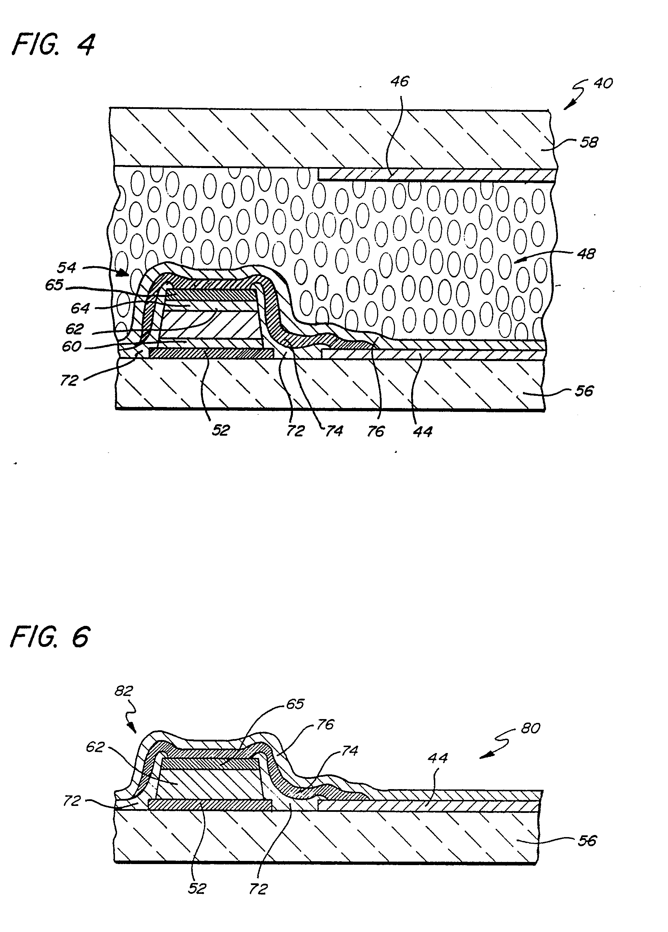

Referring now to Figure 4, a partial cross-sectional side view of the liquid crystal display 40 is shown. This figure also shows a cross sectional side view of a threshold device 54 constructed according to the present invention. The liquid crystal display 40 is made of two substrates 56 and 58. In the embodiment of the invention shown, the liquid crystal display is designed for use in a transmissive mode, and, thus, both the substrates 56 and 58 are made of a transparent material such as glass. In alternate embodiments of the invention, high-temperature-resistant transparent plastic substrates are used instead of glass.

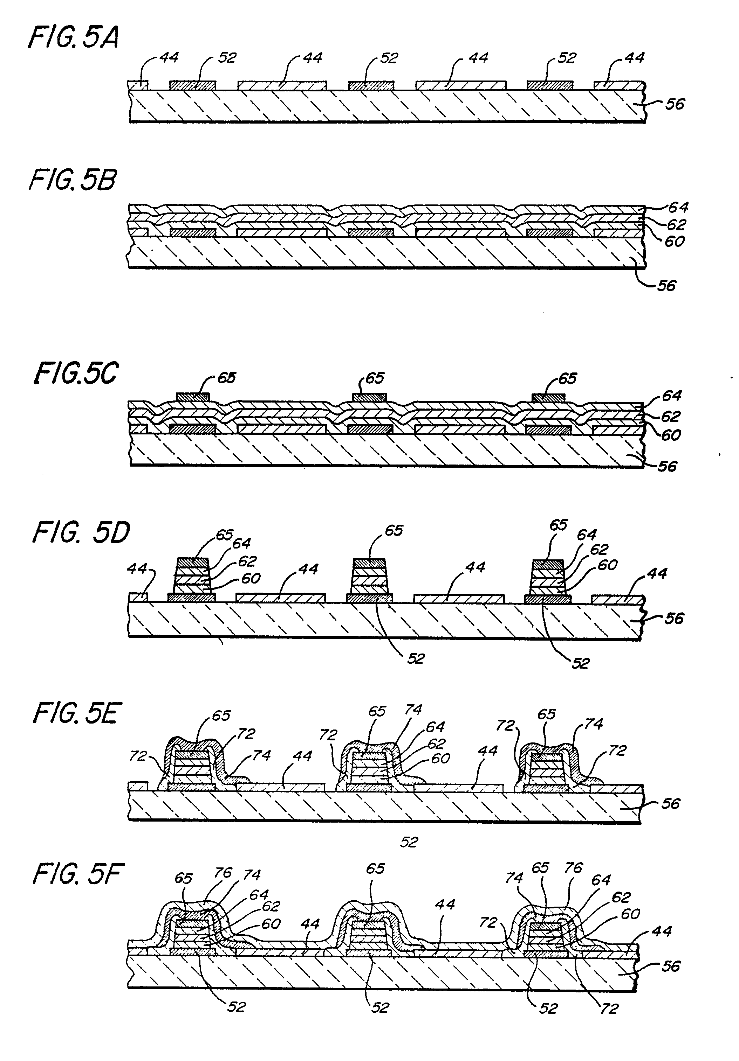

Referring now to Figures 5A through 5F, the construction of the bottom substrate subassembly used in liquid crystal display 40 is described. First a layer of transparent conductive oxide, such as indium tin oxide, is deposited upon the bottom substrate 56. Then this oxide is patterned by photolithographic means to form the plurality of bottom pixel electrodes 44, with one such bottom electrode being formed for each of the pixels 42 of the display. Then in a separate step, a layer of metal is deposited across the entire substrate and is patterned by photolithographic means to form the y address lines 52. Preferably the metal of this layer is .1 to .3 microns thick and it should be selected to be a metal which forms a good ohmic contact with the semiconductor material to be deposited above it, as is described below. Figure 5A shows the substrate 56 once the pixels 44 and the address lines 52 (which run perpendicular to the plane of the paper in Figure 5A) have been formed. For purposes of illustration, the relative width of the address lines 52 has been greatly exaggerated in Figures 5A through 5F.

The next step in the fabrication of the bottom substrate involves the deposition of three amorphous semiconductor layers, a bottom junction forming layer 60, an intermediate or common layer 62, and a top junction forming layer 64. Preferably the junction forming layers 60 and 64 are between 300 and 1000 angstroms thick and the common intrinsic layer 62 is between 2000 and 5000 angstroms thick. In the embodiment shown, the deposited amorphous semiconductor material of the junction forming layer 60 and 64 is a p+ type microcrystalline alloy of silicon including both hydrogen and fluorine as density of state reducing elements. As used herein the term "microcrystalline" is defined as a unique class of amorphous materials characterized by a volume fraction of crystalline inclusions, which is greater than a threshold value at which the onset of substantial changes in certain key parameters, such as electrical conductivity, band gap and absorption constant, occurs. It is to be noted that pursuant to the foregoing definitions, the microcrystalline, p-doped semiconductor alloy material of the layers 60 and 64 falls within the generic term "amorphous". A more detailed description of such microcrystalline material and the methods for making it is given in U.S. patent application Serial No. 701,320, entitled "Improved P-Doped Semiconductor Alloy Material and Devices Fabricated Therefrom," filed by S. Guha et al., on February 13, 1985, which is incorporated herein by reference (see corresponding European patent application, Serial No. 85307162.9 filed October 7, 1985).

The middle or common layer 62 of deposited amorphous semiconductor material is formed of a lightly n type amorphous alloy of silicon, including both hydrogen and fluorine as density of state reducing elements. This common layer 62 can be formed by plasma assisted chemical vapor deposition of silane, silicon tetrafluoride and hydrogen. Preferably the radio frequency power used during such plasma assisted chemical vapor deposition is 100 to 200 milliwatts per centimeter squared and the substrate temperature of the substrate upon which the material is deposited is held between 250° and 300° centigrade. Preferably the pressure during such deposition is between .3 to .6 Torr. Plasma assisted chemical vapor deposition of this general type is described in U.S. Patent No. 4,226,898 which was issued on October 7, 1980 in the names of Stanford R. Ovshinsky and Arun Madan for "Amorphous Semiconductors Equivalent To Crystalline Semiconductors Produced By A Glow Discharge Process", which patent is hereby incorporated herein by reference.

The major advantage of fabricating the top and bottom junction layers 60 and 64 of microcrystalline amorphous semiconductor alloy is the increased conductivity of such microcrystalline amorphous materials relative to amorphous materials that do not have such a high percent of microcrystalline inclusions. However, the device of the prevent invention can be fabricated using junction forming layers 60 and 64 which are made of non-microcrystalline amorphous semiconductor materials. In such cases theamorphous semiconductor materials. In such cases the amorphous semiconductor materials of layers 60 and 64 can be deposited by plasma assisted chemical vapor deposition of the same sort used to form the common layer 62, except that a gas containing boron, such as $BF_3$ or $B_2H_6$, is introduced into the deposition chamber along with the other gases to cause the deposited material of such layers to be doped to have p type characteristics.

Since amorphous semiconductor alloys formed of silicon have a slight n type characteristic without the addition of dopant atoms, it is possible to make a device of the present invention in which the common layer 62 is formed without the addition of dopant atoms and which nevertheless forms a p+-n-p+ type device according to the present invention. However, it may be desirable when tailoring the threshold characteristics of the device according to the present invention, to increase the n type characteristics of the common layer 62 by introducing $PH_3$ into the deposition chamber during the deposition of the layer 62, so as to dope that layer with phosphorous atoms.

In yet other embodiments of the present invention it is possible to reverse the polarities of the junction forming layers 60 and 64 and the common layer 62. In such a device the junction forming layers are formed of an n+ type material, and the common layer 62 is doped to be a lightly p type material. The p type material of the common layer can be formed by introducing a gas containing boron, such as $BF_3$ or $B_2H_6$ into the deposition chamber during the deposition of that layer. Correspondingly, the junction forming layers 60 and 64 can be made to have n type characteristics by the introduction of $PH_3$ into the deposition chamber during the deposition of the layers. Preferably the junction forming portions should be formed under conditions which will cause those layers to be microcrystalline, so as to increase their conductivity. Methods of making microcrystalline n + semiconductor material are well known in the arts of amorphous semiconductor materials.

If the threshold device 54 is to be highly symmetrical with regard to voltage polarity, it is important to insure that undesired gases do not have a chance to form on the surface of layer 60 before layer 62 is deposited upon it or upon the surface of layer 62 before layer 64 is formed on it. To accomplish this the layers 60, 62 and 64 should be deposited in a process which keeps the surface of those layers away from undesirable gases, such as those contained in ordinary air, during the formation of those layers. This can be done by forming the layers 60, 62 and 64 in one chamber without the admission of air between the deposition of the three layers.

In embodiments in which the junction forming layers 60 and 64 are formed of p + material, the address lines 52 are formed of a metal such as chromium or molybdenum which forms a good ohmic contact with p + type material. In embodiments in which the junction forming layers 60 and 64 are formed of n + material, a metal such as chromium or aluminum which forms a good ohmic contact with such an n + type material is used.

Once the three layers of amorphous semiconductor material 60, 62 and 64 have been deposited upon the substrate 56, as shown in Figure 5B, a layer 65 of a metal is deposited on top of the junction forming layer 64. The layer 65 is preferably approximately 3000 angstroms thick and is preferably made of a metal such as chromium which makes good ohmic contact with the material of the top junction forming portion 64. Once the metal layer 65 has been deposited, it is patterned photolithographically into squares which lie over those portions of the address line 52 which are to have a threshold device 54 formed upon them, as is shown in Figure 5C. Next the photoresist layer 66 is developed so that all of its exposed portions are removed. Then the entire structure on the substrate 56 is submitted to an etch which uses the remaining portions of metal layer 65 as a mask. This etching process removes all of the amorphous semiconductor materials of the layers 60, 62 and 64 except for that lying over the portions of the address lines 52 where threshold switches 54 are to be formed. As a result, the structure has the appearance shown in Figure 5D.

Next a layer 72 of insulating material such as silicon oxide ($SiO_x$), silicon nitride ($Si_xN_y$), siliconoxynitride ($SiO_xN_y$), or polyimide is deposited over all of the substrate 56. Then, using a photolithographic step, this insulating layer 72 is patterned and etched to uncover the bottom pixels 44 and a portion of the metal layer 65 on top of the threshold device 54. The metal layer 65 acts as an etchstop. This is important when the insulating layer 72 is made of silicon dioxide, since most enchants which etch through silicon dioxide etch through amorphous silicon alloys as well. The metal layer 65, however is relatively impervious to such etchants, and prevents them from damaging the threshold device 54.

After the insulating layer 72 has been etched, a layer 74 of metal is deposited and patterned by photolithographic means so as to make contact through the opening in the insulating layer 72 with the metal layer 65. The portion of the metal layer 74 which contacts the metal layer 65 of each threshold device 54, also makes contact with a portion of the surface of the bottom electrode 44 associated with that threshold device, electrically connecting the threshold device 54 in series between the address line 52 and its adjacent pixel 44.

After the metal layer 74 has been deposited and patterned, a second insulating layer 76, made of material similar to that in the first insulating layer 72 is deposited over the metal layer,so as to electrically insulate that metal layer from the liquid crystal material in the display of which the substrate 56 is to be part. Preferably this insulating layer is left covering all of the substrate 56, including the bottom pixel electrode 44. Such an insulating layer forms a substantial barrier to current flow between the upper and lower pixel electrodes of the completed display. This reduces electrochemical degradation of the display's liquid crystal material.

The metal layer 74 is between 1000 and 3000 angstroms thick. It is patterned to cover all of the semiconductor material in layers 60, 62, and 64 associated with each device 54. Thus, in conjunction with the metal of the address lines 52, it prevents any light from striking the amorphous semiconductor of that layer. This is important since the semiconductor material of layer 62 is highly photoconductive, and, if ambient light were not blocked from it, the operating characteristics of the devices 54 would be adversely affected.

Once the substrate 56 has the structure shown in Figure 5F, it is assembled in conjunction with the top substrate 58 to form a liquid crystal display. The top substrate 58 has a top pixel electrode 4 formed on it from a light transmissive conductive oxide, such as indium tin oxide. The electrodes 46 are patterned photolithographically to correspond in number and position to the bottom electrodes 44. Before the assembly of the light influencing display 40 is complete, a thin layer of light influencing material 48 is sealed in place between its two substrates 56 and 58. As is well known in the art of liquid crystal displays, when a voltage is applied between a bottom electrode 44 on the substrate 56 and its opposing top electrode 44 on the upper substrate 58, that voltage changes the optical properties of the light influencing material 48 located between the two electrodes. The application of a voltage between electrodes of a pixel changes the orientation of the molecules of the liquid crystal material 48 between those electrodes, changing the ability of light to pass through that liquid crystal material.

As is well known in the art of flat panel displays, many types of liquid crystal displays require polarizing and alignment layers in association with their pixels. Such polarizing and alignment layers have not been shown in Figure 4 for purposes of simplification, since the nature of such layers is well known in the art of liquid crystal displays.

Referring now to Figure 6, an alternate embodiment of the invention is shown which includes a bottom substrate assembly 80 for use in a liquid crystal display. This bottom substrate assembly is identical to the bottom substrate assembly shown in Figure 4, except that its threshold switch 82 has junction forming portions formed of metal, which make Schottky barrier junctions with the semiconductor material of the common layer 62, rather than junction forming portions of amorphous semiconductor material, as shown in Figure 4. In the subassembly 80, the address lines 52 and the metal layer 65 are both formed of a metal such as platinum, palladium or gold which forms a Schottky barrier with the relatively intrinsic amorphous semiconductor material of the common layer 62. Such metals can also be used when the common layer 62 is formed of lightly n doped material. In alternate embodiments of the invention in which the common layer 62 is formed of p doped material, the address line 52 and the metal layer 65 are formed of a material such as aluminum which forms a Schottky barrier with such p type materials.

The operation of the threshold device 82, which uses Schottky barriers, is substantially identical to the operation of the threshold device 54, which uses p -n junctions. The device 82 forms two back-to-back diodes. Thus, when a voltage is applied between the address line 52 and the metal layer 65, one of the junctions is forward biased and the other is reverse biased. When the voltage applied across the threshold device 82 is below its threshold voltage, the depletion region associated with the forward and reverse biased junctions do not touch, and thus the device acts as two back-to-back diodes separated by a resistance. As a result, current flow across the device is substantially prevented by the reverse biased junction. However, when the voltage applied across the device 82 is sufficient to exceed its threshold, the depletion region associated with its reverse biased junction extends across the common layer 62 to touch the depletion region associated with its forward biased junction, and thus punch-through is achieved. Once punch-through is achieved the device ceases operating as two separate back-to-back diodes and instead operates in the highly conductive punch-through mode described above with regard to other embodiments of the invention.

Referring now to Figures 7 and 8, it is shown how threshold devices of the present invention can be combined in series and in parallel to form circuit devices which also have bidirectional threshold characteristics. In Figure 7 a combination circuit element 90 is shown which is formed from two threshold devices 92 and 94 electrically connected in series between two conductive terminals 96 and 98. One of the two electrical contacts of the threshold device 92 is connected to the terminal 96. The other is connected to one of the electrical contact of the threshold device 94. The other electrical contact of the threshold device 94 is connected to the electrical terminal 98. As a result, when a voltage is applied between the two conductors 96 and 98, a voltage is applied between the two electrical contacts of each of the devices 92 and 94. The composite device 90 acts as a bidirectional threshold device with its threshold in each direction between its terminals 96 and 98 being equal to the sum of the threshold voltages of each of its two devices 92 and 94 in that direction. Thus if each of the threshold devices 92 and 94 has a five volt threshold in both directions, the composite device 90 will have a ten volt threshold in each direction. If it is desired that the composite device 90 have an even greater threshold voltage, more than two threshold devices can be connected in series to provide such a higher threshold.

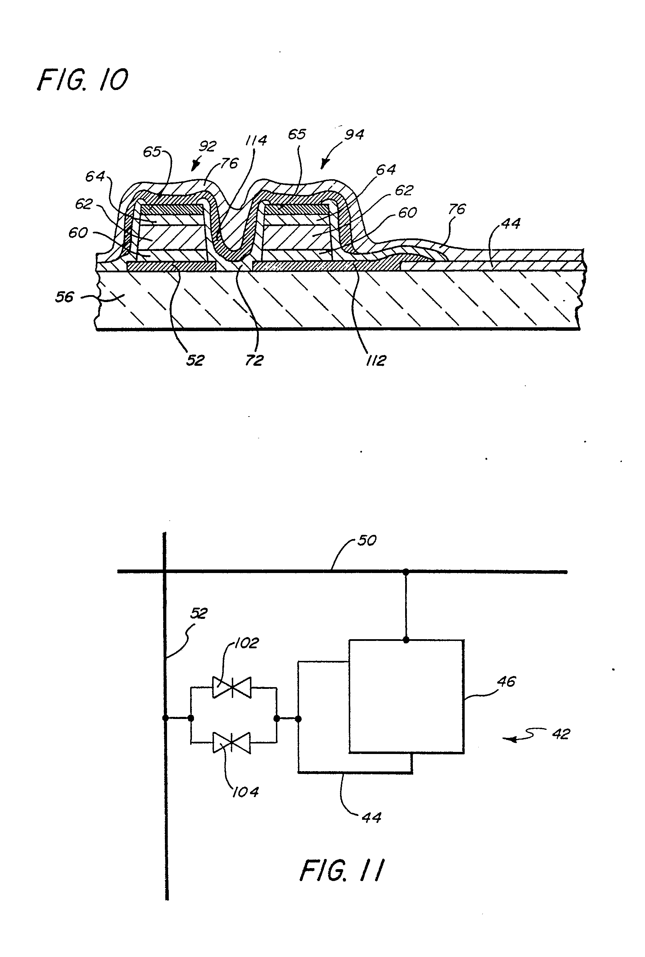

Another advantage of the circuit shown in Figure 7 is that its combination of threshold devices 92 and 94 enables common asymmetries in the current/voltage characteristics of its two devices to be cancelled out. This is important because when threshold devices of the present invention are formed of deposited layers, with a common semiconductive layer sandwiched between an upper and lower junction forming layer, the current/voltage characteristic of the resulting device may not be exactly the same in the direction pointing down from the upper junction forming layer as it is in the direction pointing up from the lower junction forming layer. This is particularly true if vacuum is broken between the deposition of layers, causing the junctions between layers to be contaminated with atoms from air. However, when the two devices 92 and 94 are formed near each other on a common substrate, it is likely that any asymmetrical properties had by one will also be had by the other. In such a case, any asymmetries in the devices 92 and 94 are cancelled out by connecting the two devices in series so that the voltage applied across one points down from its upper junction forming portion and so that the voltage applied across the other points up from its lower junction forming portion. An example of such a connection is described below with regard to Figure 10.

Figure 8 shows an alternate embodiment of the invention in which two threshold devices of the present invention, 102 and 104, are connected electrically in parallel between two terminals 106 and 108. The combination threshold device 100 formed from the two individual devices 102 and 104 has a threshold voltage in each direction equal to the lowest threshold voltage of either device 102 and 104 in that direction. Thus the parallel combination device 100 does not have the high threshold voltages associated with the serial combination device 90 shown in Figure 7. The parallel device 100 enables asymmetries in the current/voltage characteristics of its two devices 102 and 104 to cancel out, without the higher threshold associated with the device 90.

Referring now to Figure 9, a schematic electrical circuit diagram is shown of a pixel 42 which is similar to those in Figure 3 except that its bottom pixel electrode 44 is connected to its associated y lines through a series connection of two threshold devices 92 and 94 similar to that shown in Figure 7.

Referring now to Figure 10, a partial cross sectional side view of a liquid crystal display substrate 110 is shown. This cross section reveals a connection between a lower pixel electrode 44 and its associated address line 52, which connection is of the type shown schematically in Figure 9. The structure shown in Figure 10 is made in substantially the same way as that shown in Figures 4 and 5A -5F. The difference is that the structure shown in Figure 10 has two threshold devices 92 and 94 instead of the one shown in Figure 4. The two threshold devices 92 and 94 are formed out of the same layers of semiconductor material 60, 62 and 64. As a result, any asymmetries in the current/voltage characteristic between the top and bottom junction forming portions of the two devices tend to be similar. The two threshold devices 92 and 94 are electrically connected in the manner shown in Figure 10, with the bottom junction forming portion 60 of the device 94 connected through a metal contact 112 to the pixel electrode 44, with the top junction forming portions of the devices 92 and 94 connected together by metal layer 65 and a metal contact 114, and with the bottom junction forming portion 60 of the device 92 connected to the address line 52. When a voltage is applied between the pixel electrode 44 and the address line 52, that voltage is applied in opposite directions across the devices 92 and 94. As a result of this, the asymmetries of the current/voltage characteristics of the two devices 94 and 92 tend to cancel out, and the circuit element formed by the combination of the two devices tends to have substantially symmetrical current/voltage characteristics. In addition, the combination of the two devices 92 and 94 has a threshold voltage in each direction equal to the sum of the threshold voltages across the individual devices 92 and 94 in that direction.

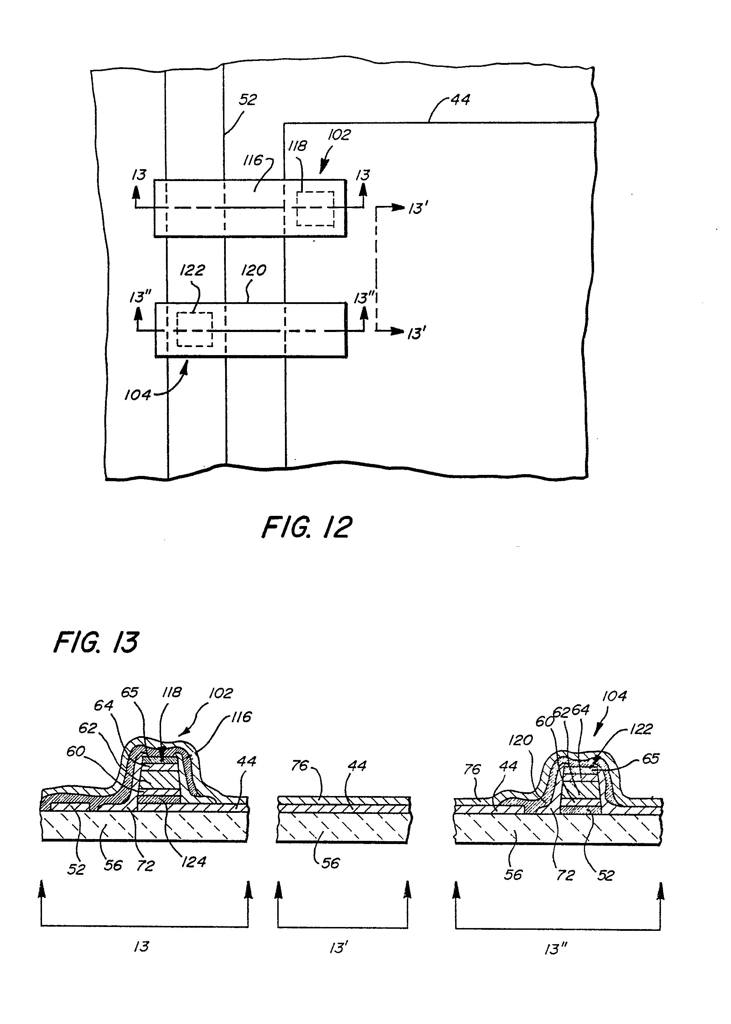

Referring now to Figure 11, a schematic electrical circuit diagram is shown of a pixel which is substantially identical to that shown in Figure 9. The difference is that in Figure 11, the bottom pixel electrode 44 is connected to its associated y line 52 through two threshold devices connected in parallel, in a manner similar to that shown in Figure 8, rather than being serially connected, as is shown in Figure 9. Figures 12 and 13 show how such a parallel connection is constructed according to one embodiment of the invention. Figure 12 is a partial top plan view of a bottom substrate subassembly upon which the pxiel electrode 44 and the address line 52 are formed. A metal connection 116 is connected at one end to the address line 52. The punch-through threshold device 102 is formed between the other end of the metal connection 116 and the pixel electrode 44. The location of the threshold device 102 is indicated by a square shaped dotted line 118, which indicates the contact via between the top metal layer 116 and the metal layer 65 of the threshold device 102. A metal connector 120 is connected at one end to the pixel electrode 44. The threshold device 104 is formed between the other end of the metal connector 120 and the address line 52. The location of the threshold device 104 is indicated by the dotted square line 122, which indicates the location of the contact via between the top metal layer 120 and the metal layer 65 of the threshold device 104.

Figure 13 represents a U-shaped cross section of the structure of Figure 12, showing the two paths of the parallel connection between the electrode 44 and the address line 52. The threshold devices 102 and 104 are formed in substantially the same manner as the threshold devices described with regard to Figures 4, 5A -5F and 10. The bottom junction forming portion 60 of the threshold device 102 is formed on top of a layer 124 of a metal, such as chromium, which is placed on top of a portion of the pixel 44. The metal layer 65 on top of the device 102 is connected to the address line 52 thorugh a chromium metal contact 116. The threshold device 104 has its bottom junction forming portion 60 formed directly on top of the address line 52. Its metal layer 65 is connected to the pixel 44 through a top metal connecting layer 120. It can be seen from Figure 13, that when a voltage is applied between the pixel electrode 44 and the address line 52, one of the threshold devices 102 and 104 has a voltage applied across it in a direction pointing from its bottom junction forming portion toward its top, whereas the other has the field applied across it in the opposite direction. Since the layers of the threshold devices 102 and 104 are formed in the same deposition processes, any asymmetries in their current/voltage characteristics should be very similar. As a result, any such asymmetries should be substantially cancelled out when the two threshold devices are operated in parallel.

One advantage of the present invention is that its use of deposited amorphous semiconductor materials enables high quality, relatively high threshold threshold devices to be deposited on substrates at a relatively low temperature. In the embodiment stated above, the deposition of the relatively intrinsic common layer 62 preferably occurs upon a substrate having a temperature of 250° to 300° centigrade. Even lower temperatures can be used with good results. As is set forth in the above mentioned Japanese patent application Serial No. 246126/85, the p+ microcrystalline amorphous semiconductor material of the junction forming layers 60 and 64 can be deposited on substrates ranging between 150° and 275° centigrade. As a result of these low deposition substrate temperatures, it is possible to form the threshold switches of the present invention on a wide variety of surface, including substrates made of glass and certain high temperature plastics. This is very different than devices fabricated of crystalline material, which can only be formed at high temperatures, and which can normally only be formed on crystalline substrates. Since crystalline substrates are more expensive than those made of glass or plastic, this makes the threshold switches of the present invention less expensive than crystalline threshold switches. In addition, crystalline substrates are currently limited as to size, with it being difficult to make crystalline substrates much larger than 6 inches in diameter. Thus the present invention allows high quality, relatively high threshold threshold devices to be made on integrated circuits which are larger than those which can be formed on crystalline substrates.

From the foregoing, it is apparent that the threshold device of the present invention can be formed of deposited materials, and furthermore, that they can be formed over relatively inexpensive, large area substrates. In all the embodiment described above, the threshold devices of the current invention were made to be relatively symmetrical with regard to voltage polarity. However, it is possible to purposely make threshold switches according to the present invention which are quite asymmetrical. This can be done, for example, by causing one of the threshold device's two junction forming portions to have different electrical properties than the other. For example, one of the junction forming portions could be more heavily doped than the other. Alternately one of the junction forming portions could be made of metal, so as to form a Schottky barrier junction with the common semiconductor body whereas, the other junction forming portion could be formed of semiconductor material. In yet another embodiment of the invention, one of the junction forming portions is formed of the surface layer of a crystalline substrate and the common semiconductor body and the second junction forming portion are formed of amorphous semiconductor materials deposited on that substrate.

In the embodiments described above, the threshold device of the present invention was shown embodied in a liquid crystal display. However, it is to be understood that the threshold switch of the present invention can be used in light influencing displays other than liquid crystal displays, and that it has uses in host of other circuit applications besides that as isolation devices for the pixels of light influencing displays. Such threshold devices are capable of use generally in voltage clamping and current controlling functions of the type described above in the Background of the Invention. It is recognized, of course, that those skilled in the art may make various modifications or additions to the preferred embodiments chosen to illustrate the invention without departing from the spirit and scope of the present contribution to the art.

Claims

1. A threshold device (10; 40;82) comprising: a common body (12,62) of deposited amorphous semiconductor material; and two separate electrical contacts (14,16), each having a junction forming portion (20,21; 60,64; 52,65) in contact with said common body, said junction forming portions each forming a junction (22,24) having a depletion region (26,28) in the semiconductor material of said common body, so that when a voltage is applied in one direction between said two contacts one of said junctions is forward biased and the other reverse biased, the spacing between said junctions and the electrical properties of said semiconductor material and said junctions being such that when a preselected voltage is applied between said contacts, the depletion region formed in said reverse biased junction extends all the way to the depletion region of the forward biased junction, greatly increasing the conductivity between said two contacts, said preselected voltage being less than that required to cause avalanche breakdown across said reverse biased junction.

2. A threshold device as described in Claim 1, wherein said semiconductor material of said common body has a first conductivity type, either p type or n type.

3. A threshold device as described in Claim 2, wherein said semiconductor material of said common body is a substantially intrinsic amorphous silicon alloy, which has an n type conductivity.

4. A threshold device as described in Claim 2, wherein said semiconductor material of said common body is lightly doped with dopants of said first conductivity type.

5. A threshold device as described in Claim 2, wherein at least one of said junction forming portions is formed of a semiconductor material substantially more heavily doped and having the opposite conductivity type from said semiconductor material of said common body.

6. A threshold device as described in Claim 5, wherein the other of said junction forming portions is also formed of a semiconductor material substantially more heavily doped and having the opposite conductivity type from said semiconductor material of said common body.

7. A threshold device as described in Claim 6, wherein said first conductivity type of said common body is p type and said opposite conductivity type of said junction forming portions is n+ type.

8. A threshold device as described in Claim 6, wherein said first conductivity type of said common body is n type and said opposite conductivity type of said junction forming portions is p+ type.

9. A threshold device as described in Claim 5, wherein said semiconductor material of said at least one junction forming portion is a deposited amorphous semiconductor material.

10. A threshold device as described in Claim 9, wherein said semiconductor material of said at least one junction forming portion is an amorphous alloy of silicon which includes hydrogen or fluorine as a density of states reducing element.

11. A threshold device as described in Claim 10, wherein said amorphous alloy of silicon in said at least one junction forming portion includes both hydrogen and fluorine as density of states reducing elements.

12. A threshold device as described in Claim 8, wherein said at least one junction forming portion is a deposited microcrystalline semiconductor material.

13. A threshold device as described in Claim 12, wherein said microcrystalline semiconductor material is an alloy of silicon containing fluorine as a density of states reducing element.

14. A threshold device as described in Claim 12, wherein the other of said junction forming portions is also a microcrystalline semiconductor material.

15. A threshold device (82) as described in Claim 1, wherein the junction forming portion (52 or 65) of at least one of said electrical contacts is formed of a metal which forms a Schottky barrier junction in contact with said semiconductor material of said common body.

16. A threshold device as described in Claim 1, wherein said spacing between said junctions through said common body is between 2000 angstroms and 5000 angstroms.

17. A threshold device as described in Claim 1, wherein said semiconductor material of said common body is an amorphous alloy of silicon which includes hydrogen or fluorine as a density of states reducing element.

18. A threshold device as described in Claim 17, wherein said amorphous alloy of silicon in said common body includes both hydrogen and fluorine as density of states reducing elements.

19. An integrated circuit device (90,100) comprising:

two electrical conductors (96,98; 106,108; 52,112;

52,44);

two threshold devices (92,94;102,104), each of said threshold devices including a common body (62) of deposited amorphous semiconductor material, and two separate electrical contacts (52,65; 112 or 124,65), each having a junction forming portion - (60,64) in contact with said common body, said junction forming portions each forming a junction having a depletion region in the semiconductor material of said common body, so that when a voltage is applied in one direction between said two contacts one of said junctions is forward biased and the other reverse biased, the spacing between said junctions and the electrical properties of said semiconductor material and said junctions being such that when a preselected voltage is applied between said contacts, the depletion region formed in said reverse biased junction extends all the way to the depletion region of the forward biased junction, greatly increasing the conductivity between said two contacts, said preselected voltage being less than that required to cause avalanche breakdown across said reverse biased junction; and

means (112,114; 116,120) for electrically connecting said two threshold devices between said two electrical conductors.

20. An integrated circuit device (90) as described in Claim 19, wherein said means (112,114) for electrically connecting said two threshold devices - (92,94) connects said threshold devices in series between said two conductors (96,98; 52,112).

21. An integrated circuit device (90) as described in Claim 20, further including a substrate (56) and wherein both of said threshold devices are formed adjacent to said substrate in at least first, second and third vertically displaced layers (60,62,64), and wherein the junction forming portions of each threshold device constitute the first and third layers (60,64) of each said device and the common body of each threshold constitutes the second and intermediate layer (62) of each said device,

wherein said means for electrically connecting said two threshold devices connects said threshold devices so that the application of a first voltage to said two electrical conductors produces a first applied field between the first and third layers of one threshold device and a second applied field between the first and third layers of the other threshold device, the direction of each said field being opposite to the direction of the other.

22. An integrated circuit device (100) as described in Claim 19, wherein said means (116,120) for electrically connecting said two threshold devices connects said threshold devices (102,104) in parallel between said two conductors (52,44).

23. An integrated circuit device (100) as described in Claim 22 further including a substrate (56) and wherein both of said threshold devices are formed adjacent to said substrate in at least first, second and third vertically displaced layers (60,62,64), and wherein the junction forming portions of each threshold device constitute the first and third layers (60,64) of each said device and the common body of each threshold constitutes the second and intermediate layer (62) of each said device,

wherein said means (116,120) for electrically connecting said two threshold devices connects threshold devices so that the application of a first voltage to said two electrical conductors produces a first applied field between the first and third layers of one threshold device and a second applied field between the first and third layers of the other threshold device, the direction of each said field being opposite to the direction of the other.

24. A light influencing display (40) comprising:

a plurality of pixels (42), each including two opposing electrode surfaces (44,46) adapted to have light influencing material placed therebetween;

a plurality of address lines (50,52) enabling each of said pixels to be selectively addressed; and

a threshold device (54), placed in electrical series between one of the electrode surfaces (44) of at least one of said pixels and at least one of said address lines used to address said pixel, said threshold device including a common body (62) of deposited amorphous semiconductor material and two separate electrical contacts, each of said contacts having a junction forming portion (20,21; 60,64) in contact with said common body, said junction forming portions each forming a junction - (22,24) having a depletion region (26,28) in the semiconductor material of said common body, so that when a voltage is applied in one direction between said two contacts one of said junctions is forward biased and the other reversed biased, the spacing between said junctions and the electrical properties of said semiconductor material and said junctions being such that when a preselected voltage is applied between said contacts, the depletion region formed in said reverse biased junction extends all the way to the depletion region of the forward biased junction, greatly increasing the conductivity between said two contacts, said preselected voltage being less than that required to cause avalanche breakdown across said reverse biased junction.

25. A light influencing display as described in Claim 24, wherein each of said pixels has at least one of said threshold devices connected in series between at least one of its electrode surfaces and at least one of the address lines used to address it.

26. A light influencing display as described in Claim 24, further including a substrate (56) on which at least one of the electrode surfaces of each of said pixels and at least one of said address lines used to address each pixel are formed, wherein said at least one threshold device is formed of materials deposited on said substrate.

27. A light influencing display as described in Claim 26, wherein said substrate is formed of glass.

28. A light influencing display as described in Claim 26, wherein said two junction forming portions and said common body are each formed of a layer of deposited material supported by said substrate with the layer of said common body located between the layers of said two junction forming portions.

29. A light influencing display as described in Claim 24, wherein said semiconductor material of said common body has a first conductivity type, either p type or n type, and wherein said junction forming portion of at least one of said electrical contacts is formed of a semiconductor material substantially more heavily doped and having the opposite conductivity type from said semiconductor material of said common body.

30. A light influencing display as described in Claim 29, wherein the other of said junction forming portions is also formed of a semiconductor material substantially more heavily doped and having the opposite conductivity type from said semiconductor material of said common body.

31. A light influencing display as described in Claim 29, wherein said semiconductor material of said at least one junction forming portion is a deposited amorphous semiconductor material.

32. A light influencing display as described in Claim 31, wherein said semiconductor material of said forming portion is an amorphous alloy of silicon which includes hydrogen or fluorine as a density of states reducing element.

33. A light influencing display as described in Claim 31, wherein said at least one junction forming portion is a microcrystalline semiconductor material.

34. A light influencing display as described in Claim 24, wherein said junction forming portion of at least one of said electrical contacts is formed of a metal (52 or 65) which forms a Schottky barrier junction in contact with said semiconductor material of said common body.

35. A light influencing display as described in Claim 24, wherein said spacing between said junctions through said common body is between 2000 and 5000 angstroms.

36. A light influencing display as described in Claim 24, wherein said semiconductor material of said common body is an amorphous alloy of silicon which includes hydrogen or fluorine as a density of states reducing element.

37. A light influencing display as described in Claim 36, wherein said amorphous alloy of silicon in said common body includes both hydrogen and fluorine as density of states reducing elements. 38. A light influencing display as described in Claim 24, further comprising a light influencing material between opposing electrode surfaces of said plurality of pixels, said light influencing material being a liquid crystal material (48).

39. A light influencing display as described in Claim 24, wherein two of said threshold devices - (92,94) are electrically connected between said electrode surface of at least one pixel and said at least one address line (Figure 9).

40. A light influencing display as described in Claim 39 further comprising means (112,114) for electrically connecting said two threshold devices in series between said electrode surface and said address line.

41. A light influencing display as described in Claim 40 further including a substrate (56), and

wherein both of said two threshold devices are formed adjacent to said substrate in at least first, second and third vertically displaced layers (60,62,64), and wherein the junction forming portions of each threshold device constitute the first and third layers (60,64) of each said device and the common body of each threshold constitutes the second and intermediate layer (62) of each said device,

wherein said means for electrically connecting said two threshold devices connects said threshold devices so that the application of a first voltage to said two electrical conductors produces a first applied field between the first and third layers of one threshold device and a second applied field between the first and third layers of the other threshold device, the direction of each said field being opposite to the direction of the other.

42. A light influencing display as described in Claim 39 further comprising means for electrically connecting said two threshold devices (102,104) in parallel between said electrode surface and said address line (Figure 11).

43. A light influencing display as described in Claim 42, further including a substrate (56), and

wherein both of said two threshold devices are formed adjacent to said substrate in at least first, second and third vertically displaced layers (60,62,64), and wherein the junction forming portions of each threshold device constitute the first and third layers (60,64) of each said device and the common body of each threshold constitutes the second and intermediate layer (62) of each said device,

wherein said means for electrically connecting said two threshold devices connects said threshold devices so that the application of a first voltage to said two electrical conductors produces a first applied field between the first and third layers of one threshold device and a second applied field between the first and third layers of the other threshold device, the direction of each said field being opposite to the direction of the other.

44. A subassembly (Figures 3; 10; 12, 13) for a light influencing display comprising:

a substrate (56);

a plurality of pixel electrodes (44) formed on said substrate;

a plurality of address lines. (52,52a,52b,52c) formed on said substrate; and

a plurality of threshold devices (54,92,94; 102,104) formed on said substrate, with each threshold device being electrically connected in between a pixel electrode and one of said address lines, each of said threshold devices including a common body - (62) of deposited amorphous semiconductor material and two separate electrical contacts, each of said contacts having a junction forming portion - (20,21; 60,64) in contact with said common body, said junction forming portions each forming a junction (22,24) having a depletion region (26,28) in the semiconductor material of said common body, so that when a voltage is applied in one direction between said two contacts one of said junctions is forward biased and the other reversed biased, the spacing between said junctions and the electrical properties of said semiconductor material and said junctions being such that when a preselected voltage is applied between said contacts, the depletion region formed in said reverse biased junction extends all the way to the depletion region of the forward biased junction, greatly increasing the conductivity between said two contacts, said preselected voltage being less than that required to cause avalanche breakdown across said reverse biased junction.

45. A subassembly as described in Claim 44, wherein said substrate is formed of glass.

46. A subassembly as described in Claim 44, wherein said two junction forming portions (60,64) and said common body (62) are each formed of a layer of deposited material supported by said substrate, with the layer of said common body located between the layers of said two junction forming portions.

47. A method of forming a threshold device - (54,82) comprising:

depositing a common layer of amorphous semiconductor material on a substrate having a first junction forming portion (60 or 52) on its surface, said first junction forming portion forming a junction having a depletion region in the semiconductor material of said common layer;

depositing a second junction forming portion (64 or 65) on top of said common layer, said second junction forming layer also forming a junction having a depletion region in the semiconductor material of said common layer, so that when a voltage is applied in one direction between said two junction forming portions, one of said junctions is forward biased and the other reversed biased, the spacing between said junctions and the electrical properties of said semiconductor material and said junctions being such that when a preselected voltage is applied between said the junction forming portions, the depletion region formed in said reverse biased junction extends all the way to the depletion region of the forward biased junction, greatly increasing the conductivity between said two contacts, said preselected voltage being less than that required to cause avalanche breakdown across said reverse biased junction.

48. A method as described in Claim 47, further including forming said first junction forming portion upon said substrate before the deposition of said common layer, said forming of said first junction forming portion including depositing the material of which it is formed upon said substrate in a layer.

49. A method as described in Claim 48, in which said layers of said first and second junction forming portions (60,64; 52,65) and said common layer (62) are each deposited as continuous layers over an extended region of said substrate, and said layers are etched photolithographically to form a plurality of said non-linear devices.

50. A method as described in Claim 49, in which said layers are all etched together in one photolithographic etching process.

FIG. IA

FIG. IB

FIG. IC

FIG. ID

**FIG. 2**

**FIG. 3**

FIG. 4

FIG. 6

FIG.5A

FIG.5B

FIG.5C

FIG. 5D

FIG.5E

FIG.5F

FIG. 7

FIG. 8

FIG. 9

*FIG. 10*

*FIG. 11*

**FIG. 12**

**FIG. 13**